# EUROPEAN PATENT APPLICATION

(11) **EP 2 197 258 A1**
(43) Date of publication of application: **16.06.2010**
(21) Application number: 08253999.0
(22) Date of filing: 12.12.2008
(51) Int. Cl.: H05K 9/00

(54) **Shield**

(71) Applicant: BAE Systems PLC, 6 Carlton Gardens London SW1Y 5AD (GB)
(72) Inventor: The designation of the inventor has not yet been filed
(74) Representative: BAE SYSTEMS plc Group IP Department

(57) **Abstract**

A printed circuit board shield (100) is provided. The shield comprises a sealing surface and a shielding surface.
The sealing surface is configured to cooperate with, and be connectable to, a sealing region of a printed circuit board upon assembly therewith.
The shielding surface is substantially parallel to but offset from, the sealing surface. A concave cover for receiving at least part of the printed circuit board is thereby defined.
The shielding surface comprises an array of perforations (130) formed therethrough. The array of perforations is configured to correspond to a location of an electronic component mounted on the printed circuit board.

## Description

The present invention relates to the field of shielding devices, in particular to a shield for protecting electrical components of a radar installation.

Transmit/receive units (TRU) of a phased radar installation use high power amplifiers together with other heat generating electrical components. Consequently, the temperature of the TRU increases in operation which can be detrimental to the performance and service life thereof. Cooling of the TRU is, therefore, critical. It is also desirable to minimise power consumption of the phased radar installation such that heat generated thereby is correspondingly reduced.

In conventional systems the units are flushed with cooling air in order to reduce the temperature of the operating environment of the electrical components such that good heat transfer therefrom can be achieved. However, significant air flow is required in order to effect a desired level of cooling. Generation of this air flow requires a significant amount of power and further contributes to heat generation.

It is desirable to enhance cooling of the electrical components involved whilst minimising any increased generation of heat.

According to a first aspect, the present invention provides a printed circuit board shield comprising:
a sealing surface configured to cooperate with and be connectable to a sealing region of a printed circuit board upon assembly therewith; and
a shielding surface, substantially parallel to but offset from the sealing surface to thereby define a concave cover for receiving at least part of the printed circuit board, wherein the shielding surface comprises an array of perforations formed therethrough, the array of perforations being configured to correspond to a location of an electronic component mounted on the printed circuit board.

Introduction of a shield provides improved mechanical/physical protection of electronic components located on the printed circuit board (PCB). However, such a shield would be expected to inhibit air flow around the components and, therefore inhibit cooling thereof. By providing a perforated shield that is, consequently, particularly configured to achieve cooling of the electronic components, a multi purpose functionality, including shielding and cooling, can be achieved.

Furthermore, by providing the shield in combination with the printed circuit board, the stiffness, and therefore, support of the PCB is enhanced upon installation of the shield. In particular, the shield provides protection during handling of the PCB whilst remaining light weight and, therefore, minimises the structural loading burden on a framework of the radar installation.

The offset between the shielding surface and the sealing surface may be selected in dependence on a height of the electronic component. A second shielding surface, having a second offset, may be provided. The second offset may be selected in dependence on a height of a second electronic component mounted on the printed circuit board.

The number, spacing, distribution and/or magnitude of perforations in the array may each be configured in dependence on a heat generating capacity of the, or each, electronic component.

By customising the distance of the shielding surface from particular components to be cooled, the characteristics of an impingement jet, formed in operation of the device, can be carefully controlled. This control is further enhanced by the selection of the number of perforations, the pattern of the perforations, the diameter of the perforations and/or the density of the perforations such that an optimum level of heat dissipation is achieved.

In addition to providing physical/mechanical protection, the shield may be configured to serve as a radio frequency interference screen and/or the shield may be configured to serve as an electromagnetic interference screen.

The shield may comprise a metallic material such as aluminium and/or a metallised material such as a composite, a ceramic material or a plastics material with a metallised coating. The shield may be manufactured by super-plastic forming. Consequently, a very lightweight device is achieved.

According to a second aspect, the present invention provides a transmit/receive unit (TRU) for a radar installation comprising:
a printed circuit board (PCB) comprising an antenna element having a dipole associated therewith; and
a shield of the aforementioned type, the shield being sealably connected to the PCB, whereby the TRU comprises an inlet defined by the array of perforations configured to permit ingress of cooling fluid and an outlet configured to permit egress of cooling fluid.

The printed circuit board may comprise a plurality of antenna elements and each element may have a dipole associated therewith. The TRU may comprise a plurality of inlets, each inlet may be associated with a respective antenna element. The TRU may comprise a plurality of outlets, each outlet may be associated with a respective antenna element.

According to a third aspect the present invention provides a radar installation comprising:
an antenna housing;
an array face plate, mounted within the antenna housing, the plate comprising a plurality of apertures therethrough;
a first plenum configured to receive cooling fluid;
a transmit/receive unit of the aforementioned type, mounted on and sealably connected to a surface of the array face plate, wherein the, or each, dipole of the TRU protrudes through a respective aperture, the, or each, inlet of the TRU is in fluid communication with the first plenum and the, or each, outlet of the TRU is co-located with a respective aperture.

The present invention will now be described in greater detail, by way of example only, with reference to the accompanying drawings in which:
Figure 1 represents a radar installation;
Figure 2 represents a transmit/receive unit (TRU);
Figure 3 represents a shield for the unit illustrated in Figure 2;
Figure 4 represents a cross section taken through X-X in Figure 2;
Figure 5 represents a view of a module taken on view Y depicted in Figure 2; and
Figure 6 represents a cross section taken through Z-Z of Figure 4.

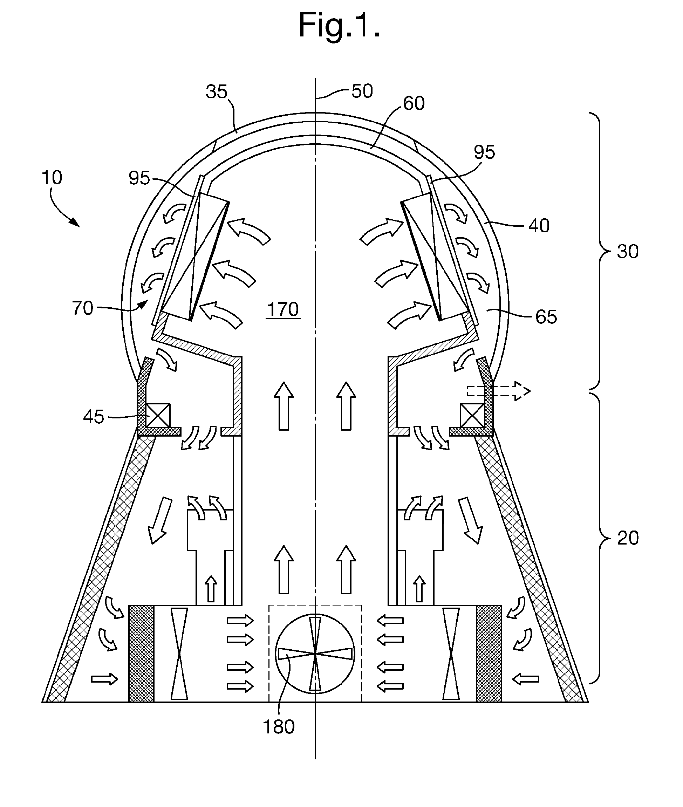

Figure 1 illustrates a radar installation comprising a support structure 20 which may be mounted, for example, on the deck or mast head of a ship. An antenna structure 30 is mounted atop the support structure 20 via a bearing mechanism 45. The bearing mechanism 45 permits the antenna structure 30 to rotate freely about a vertical axis 50 with respect to the support structure 20. The antenna structure 30, comprises an antenna housing 35 together with one or more radomes 40. The, or each, radome 40 is made from a non-metallic material such as fibre glass and is, therefore, transparent to RF signals while the material of the housing 35 is substantially opaque to such signals.

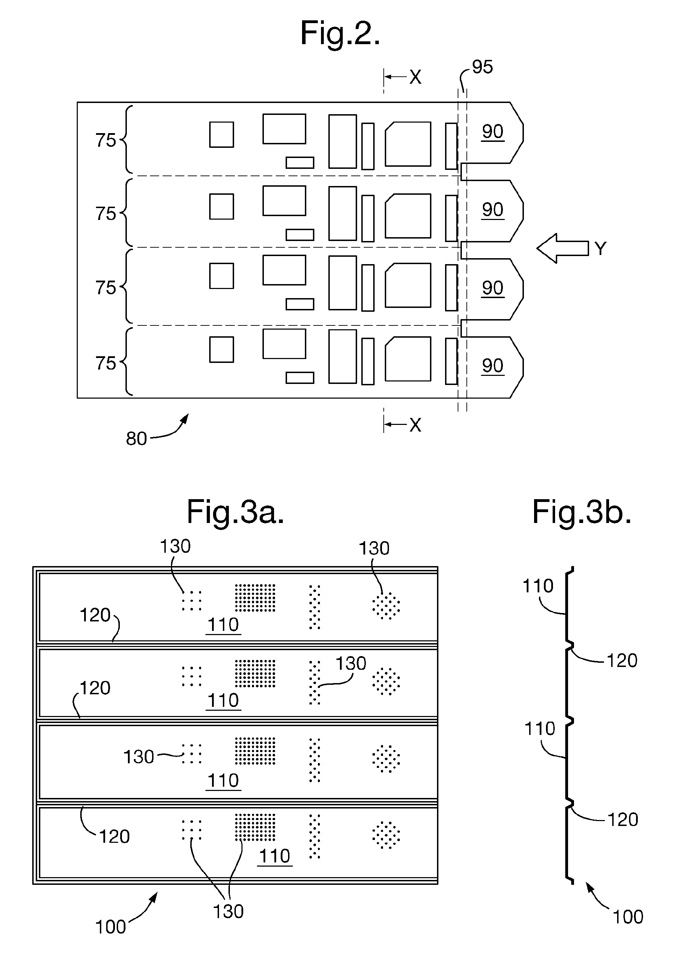

The antenna structure 30 comprises an antenna assembly 60. In this embodiment, the antenna assembly 60 comprises two array faces 70, each aligned with a respective radome 40 and defining a chamber 65 between each array face 70 and a respective radome 40. Each array face 70 comprises a number of antenna elements 75 evenly distributed across the array face. Figure 2 illustrates a transmit/receive unit (TRU) 80 comprising four antenna elements 75. Each antenna element 75 comprises a number of electronic components including a high power amplifier, a core processor, a filter and a duplexer component together with a dipole 90. The TRU is arranged such that the dipole 90 of each antenna element 75 protrudes through an array face plate 95 whilst the remainder of the TRU 80 is located behind the plate 90. Each antenna element 75 represents a different transmission/reception path.

Figure 3a illustrates a shield 100 for use in combination with the TRU 80 of Figure 2. The shield 100, in this embodiment, is made from aluminium and is manufactured using super-plastic forming. The shield 100 may be made from an alternative, light weight, material that can readily be formed into complex geometries. Light weight materials are used to ensure that the weight associated with each TRU 80 can be kept to a minimum. The material must be electrically conductive and so metallic or metallised materials are considered appropriate.

The profile of the shield 100 can be seen in Figure 3b. The shield 100 is divided into four regions 110 having troughs 120 formed therebetween which, when placed adjacent to the TRU of Figure 2, serve to isolate the transmission/reception path of each antenna element 75 from the transmission/reception path of adjacent antenna elements. Formation of troughs 120 additionally serve to stiffen the shield 100 as they act as ribs. Consequently, the shield 100 inhibits bending of the TRU 80 in addition to providing a physical barrier. Each feature serves to protect against mechanical damage to the electronic components of the TRU 80.

Upon assembly, a shield 100 is connected to each transmit/receive unit 80. If the TRU 80 comprises components on both sides a second, appropriately shaped shield 100' can be attached to the opposing side of the TRU 80.

Arrays of perforations 130 are formed through the thickness of shield 100 in the regions 110. Each array of perforations 130 is located such that it corresponds to one of the electronic components mounted on the transmit/receive unit 80. In use, a coolant fluid passes through the perforations 130 to effect cooling of the electronic components of the TRU 80. In providing an array of perforations 130 a high surface area can be cooled with a relatively small amount of impinging cooling fluid. Excellent heat transfer coefficients are achieved for a given cooling fluid flow rate, *ṁ*.

In addition to physical protection of the electronic components, shield 100 acts as a RF screen and an EMC screen. Consequently, the diameter of any perforations 130 should be kept to a minimum to prevent leakage and enhance the screening properties of the shield 100. Further the shield 100 comprises a conductive material (e.g. a metallic or metallised material) to enhance the RF and EMC screening functionality. The shield is configured to be sufficiently stiff such that a robust interface is provided to which an EMC gasket can be attached in use to inhibit RF and EMC leakage between the shield 100 and the TRU 80.

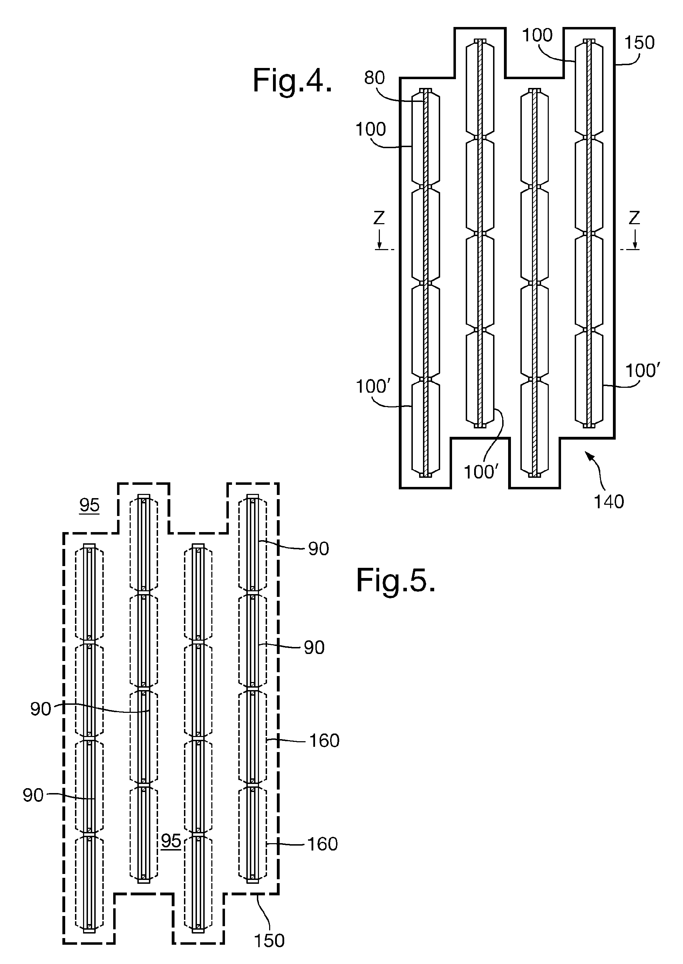

Figure 4 illustrates a transmit/receive module 140 comprising a module housing 150. Each transmit/receive module 140 comprises four TRU 80. Each TRU 80 is offset from an adjacent TRU as illustrated to achieve a staggered configuration whereby the antenna elements 75 are not directly aligned with one another. Figure 4 represents the image taken at a cross section X-X, depicted in Figure 2. Figure 5 represents a corresponding image when viewed from 'Y', also depicted in Figure 2.

Figure 5 illustrates the array face plate 95 having rectangular apertures 160 formed therein. Dipoles 90, from each respective antenna element 75, protrude through apertures 160 and into the chamber 65 formed between the array face plate 95 and the radome 40.

A number of modules 140 are provided adjacent one another and, together, form a sub-array. A number of sub-arrays make up the array face 70 of the antenna installation 10.

Returning to Figure 1, the array assembly 60 comprises two array faces 70, diametrically opposed from one another and forming a plenum 170 therebetween. In this embodiment, a fan 180 is provided at an inlet to the plenum 170 to enable fluid to be forced into the plenum 170 and thereby elevate the pressure therewithin. Alternatively, high pressure gas could be delivered directly to the plenum 170.

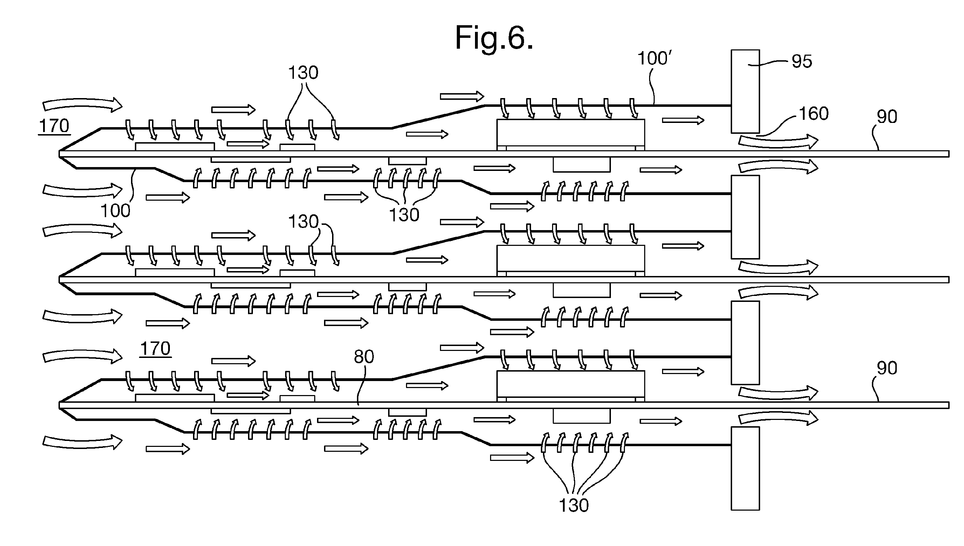

In the previous embodiment, the electronic components each have a similar depth to one another and so regions 110 are substantially planar and spaced from a surface of the component by a distance, d. If, however the electronic components vary in depth, the profile of region 110 is configured accordingly to accommodate this variation and retain the spacing, d, between the shield 100 and each component or certain components. Such a profile is illustrated in the shield shown in Figure 6.

In operation, and with reference to Figures 1 and 6, the fan 180 is caused to rotate, thereby driving cooling fluid, for example air, into the plenum 170 thus forcing the pressure in plenum 170 to rise. As the, or each, shield 100, 100' is sealably connected to the respective TRU 80, the only flow path available to the cooling fluid is through perforations 130. By virtue of the pressure difference across the shield 100, 100', fluid passing through perforations 130 is jetted in a direction substantially perpendicular to the shield 100, 100'. Each jet impinges the electronic components located on the TRU 80 adjacent to the perforations 130 to effect cooling thereof. The number, spacing and diameter of the perforations 130 can be varied so as to generate an appropriate level of cooling for the particular component to which it is directed. Furthermore, the distance, d, between each region 110 of shield 100, 100' and electronic components sited on the TRU 80 is selected to define the most efficient impact length for the jets impinging thereon.

As discussed above, impingement cooling results in very high heat transfer coefficients for a given cooling fluid flow rate, *ṁ*. The overall flow rate, *ṁ*, is regulated by designing the perforations 130 appropriately in relation to the pressure that can be achieved in the high pressure plenum 170. Preferably, jets of approximately 20-30 metres per second are achieved.

Cooling of the electronic components is thereby effected and the cooling fluid subsequently passes through rectangular apertures 160 and into the chamber 65 through the array face plate 95. Subsequently, the cooling fluid flows down through the structure 20 and returns to the fan 180 of the air conditioning unit as depicted in Figure 1.

Whilst cooling is critical, fans 180 of the type used here consume a significant level of power. Fan power increases with the cube of the flow rate. By keeping air flow to a minimum through use of impingement cooling and, in particular by careful design of perforations 130, in terms of diameter, distribution (i.e. number of, spacing between and particular pattern of perforations) together with spacing, d, between shield 100, 100' and TRU 80, power use and consequent heat generation can be minimised.

## Claims

1. A printed circuit board shield comprising:
a sealing surface configured to cooperate with and be connectable to a sealing region of a printed circuit board upon assembly therewith; and
a shielding surface, substantially parallel to but offset from the sealing surface to thereby define a concave cover for receiving at least part of the printed circuit board, wherein the shielding surface comprises an array of perforations formed therethrough, the array of perforations being configured to correspond to a location of an electronic component mounted on the printed circuit board.

2. A shield according to Claim 1, wherein the offset between the shielding surface and the sealing surface is selected in dependence on a height of the electronic component.

3. A shield according to Claim 1 or Claim 2, comprising a second shielding surface having a second offset, the second offset being selected in dependence on a height of a second electronic component mounted on the printed circuit board.

4. A shield according to any preceding claim, wherein one of the group of number, spacing, distribution and magnitude of perforations in the array are configured in dependence on a heat generating capacity of the electronic component.

5. A shield according to any preceding claim, wherein the shield is configured to serve as a radiofrequency interference screen.

6. A shield according to any preceding claim, wherein the shield is configured to serve as an electromagnetic interference screen.

7. A shield according to any preceding claim, wherein the shield comprises a metallic material.

8. A shield according to Claim 7, wherein the shield comprises aluminium.

9. A shield according to Claim 7, wherein the shield comprises a metallised material.

10. A shield according to Claim 9, wherein the shield comprises one of the group of a composite material, a ceramic material and a plastics material.

11. A shield according to any preceding claim, wherein the shield is manufactured by super-plastic forming.

12. A transmit/receive unit (TRU) for a radar installation comprising:
a printed circuit board (PCB) comprising an antenna element having a dipole associated therewith; and
a shield according to any preceding claim, the shield being sealably connected to the PCB, whereby the TRU comprises an inlet defined by the array of perforations configured to permit ingress of cooling fluid and an outlet configured to permit egress of cooling fluid.

13. A transmit/receive unit according to Claim 12, wherein the printed circuit board comprises a plurality of antenna elements, each having a dipole associated therewith.

14. A transmit/receive unit according to Claim 13, wherein the TRU comprises a plurality of inlets, each inlet being associated with a respective antenna element.

15. A transmit/receive unit according to Claim 13 or Claim 14, wherein the TRU comprises a plurality of outlets, each outlet being associated with a respective antenna element.

16. A radar installation comprising:
an antenna housing;
an array face plate, mounted within the antenna housing, the plate comprising a plurality of apertures therethrough;
a first plenum configured to receive cooling fluid;
a transmit/receive unit according to any of Claims 12 to 15, mounted on and sealably connected to a surface of the array face plate, wherein the, or each, dipole of the TRU protrudes through a respective aperture, the, or each, inlet of the TRU is in fluid communication with the first plenum and the, or each, outlet of the TRU is co-located with a respective aperture.
